# EUROPEAN PATENT SPECIFICATION

(11) **EP 4 068 927 B1**
(45) Date of publication and mention of the grant of the patent: **03.07.2024**
(21) Application number: 21306174.0
(22) Date of filing: 30.08.2021
(51) Int. Cl.: H05K 7/20

(54) **IMMERSION COOLING SYSTEM WITH DUAL DIELECTRIC COOLING LIQUID CIRCULATION**
TAUCHKÜHLSYSTEM MIT DOPPELTEM DIELEKTRISCHEM KÜHLFLÜSSIGKEITSKREISLAUF
SYSTÈME DE REFROIDISSEMENT PAR IMMERSION À DOUBLE CIRCULATION DE LIQUIDE DE REFROIDISSEMENT DIÉLECTRIQUE

(30) Priority: 01.04.2021 EP 21305427
(43) Date of publication of application: 05.10.2022
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); MAILLOT, Patrick-Gilles, 26740 Marsanne (FR)
(74) Representative: BCF Global

(56) References cited:
- EP-A2- 3 236 727
- US-A1- 2010 328 889
- US-A1- 2018 027 695
- US-A1- 2019 297 747

## Description

### CROSS-REFERENCE

The present patent application claims priority from European Patent Application Number 21305427.3, filed on April 1, 2021.

### FIELD

The present technology relates to cooling systems for immersion cooling of electronic components. In particular, an immersion cooling system implements dual dielectric cooling liquid circulation.

### BACKGROUND

Electronic equipment, for example servers, memory banks, computer discs, and the like, is conventionally grouped in equipment racks. Large data centers and other large computing facilities may contain thousands of racks supporting thousands or even tens of thousands of servers.

The racks, including equipment mounted in their backplanes, consume large amounts of electric power and generate significant amounts of heat. Cooling needs are important in such racks. Some electronic devices, such as processors, generate so much heat that they could fail within seconds in case of a lack of cooling.

Fans are commonly mounted within equipment racks to provide forced ventilation cooling to rack-mounted equipment. This solution merely displaces some of the heat generated within the racks to the general environment of the data center. Liquid cooling, in particular water cooling, has recently been introduced as an addition or replacement to traditional forced-air cooling. Cold plates, for example water blocks having internal channels for water circulation, may be mounted on heat-generating components, such as processors to displace heat from the processors toward heat exchangers. Air-to-liquid heat exchangers, for example finned tubes heat exchangers similar to radiators, may be mounted to the racks to absorb and transport some of this displaced heat toward external cooling equipment, for example cooling towers, located outside of the data center.

Immersion cooling (sometimes called immersive cooling) was more recently introduced. Electronic components are inserted in a container that is fully or partially filled with a non-conducting cooling liquid, for example an oil-based dielectric cooling liquid. Good thermal contact is obtained between the electronic components and the dielectric cooling liquid. However, an electronic component, for example a server, comprises some devices such as processors may generate most of the heat while other devices such as memory boards may generate much less heat. It is generally required to ensure circulation of the dielectric cooling liquid, within the container, at a level that is sufficient to cool the hottest devices within the electronic components. This requires the use of efficient pumps that consume a significant amount of energy. Heat sinks may be mounted on some heat-generating devices. Some other heat-generating devices may have porous surfaces so that the contact between these devices and the dielectric cooling liquid is more intimate and thus more thermally efficient. These solutions only provide a modest reduction of the amount of energy required to operate the pumps that circulation the dielectric cooling liquid within the container.

Even though the recent developments identified above may provide benefits, improvements are still desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.
EP 3 236 727 describes a system for immersion cooling computing system equipment that includes a container containing a volume of immersion cooling fluid. At least one heat generating computing system equipment component and a liquid-liquid heat exchanger are disposed in the volume of immersion cooling fluid. A manifold system is disposed between the heat generating computing system equipment component and the liquid-liquid heat exchanger to direct a flow of immersion cooling fluid between the heat generating computing system component and the liquid-liquid heat exchanger and to isolate the flow of immersion cooling fluid from a bulk amount of immersion cooling fluid. The flow of immersion cooling fluid and the bulk amount of immersion cooling fluid constitutes the volume of immersion cooling fluid.
US 2019/0297747 describes an apparatus for liquid immersion cooling. Tthe apparatus includes: a casing configured to be partly filled with a first coolant and immerse, in the first coolant, a heat generating component other than a first heat generating component in a plurality of heat generating component; a liquid cooling jacket provided in contact with the first heat generating component placed in the casing, and configured to cool the first heat generating component; a first cooling device configured to dissipate heat of a second coolant sent out from the liquid cooling jacket through a first pipe, thereby cooling the second coolant; and a first pump configured to send out the second coolant cooled by the first cooling device to the liquid cooling jacket through a second pipe.
US 2018/0027695 describes an apparatus that includes: a cooling medium bath configured to house a first refrigerant in which an electronic device is immersed: a liquid-cooling jacket configured to be provided to the electronic device and to cool the electronic device by a second refrigerant that flows in an internal section of the liquid-cooling jacket; a first pipe coupled to the cooling medium bath, to be immersed in the first refrigerant, and configured to supply the second refrigerant from an outside of the cooling medium bath to the liquid-cooling jacket; a second pipe coupled to the cooling medium bath, to be immersed in the first refrigerant, and configured to discharge the second refrigerant that flows in the internal section of the liquid-cooling jacket to the outside of the cooling medium bath; and a circulator configured to cause the first refrigerant in the cooling medium bath to stream.
US 2010/0328889 A1 describes cooled electronic modules and methods of fabrication provided with pump-enhanced, dielectric fluid immersion-cooling of the electronic device. The cooled electronic module includes a substrate supporting an electronic device to be cooled. A cooling apparatus couples to the substrate, and includes a housing configured to at least partially surround and form a sealed compartment about the electronic device. Additionally, the cooling apparatus includes dielectric fluid and one or more pumps disposed within the sealed compartment. The dielectric fluid is in direct contact with the electronic device, and the pump is an impingement-cooling, immersed pump disposed to actively pump dielectric fluid within the sealed compartment towards the electronic device. Multiple condenser fins extend from the housing into the sealed compartment in an upper portion of the sealed compartment, and a liquid-cooled cold plate or an air-cooled heat sink is coupled to the top of the housing for cooling the condenser fins.

### SUMMARY

[06] Embodiments of the present technology have been developed based on developers' appreciation of shortcomings associated with the prior art.

[07] In particular, such shortcomings may comprise (1) inability to address the cooling needs to devices that generate most of the heat; and/or (2) significant power consumption of the cooling systems.

The object of the invention is solved by a cooling system according to claim 1. Preferred embodiments are presented in the dependent claims.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a schematic diagram of an immersion cooling system in accordance with an embodiment of the present technology;
Figure 2 is a schematic diagram of another immersion cooling system in accordance with an embodiment of the present technology;
Figure 3 illustrates various types of connections of outlet pipes between a manifold and an electronic component in accordance with an embodiment of the present technology;
Figure 4 is a block diagram of an air-to-liquid heat exchanger thermally connected to a piping arrangement in accordance with an embodiment of the present technology;
Figure 5 is a block diagram of a liquid-to-liquid heat exchanger thermally connected to a piping arrangement in accordance with an embodiment of the present technology;
Figure 6 is a schematic representation of a phase change material plug for selectively allowing dielectric cooling fluid to reach a thermal transfer device in accordance with an embodiment of the present technology; and
Figure 7 is a block diagram of a system for controlling the pumps in accordance with an embodiment of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

In an aspect, the present technology introduces a cooling system having two pumps for circulating a dielectric cooling liquid in a container that receives one or more electronic components immersed in the dielectric cooling liquid. One pump is used to cause a circulation of the dielectric cooling liquid, broadly within the container. Another pump is used to direct a flow of the dielectric cooling liquid toward the electronic components. As such, the direct flow provided enhanced cooling of specific devices of the electronic components, such as for example processors that generate the most thermal energy, while the broad circulation of the liquid cooling within the container allows cooling other devices of the electronic components while generally controlling the temperature of the dielectric cooling liquid.

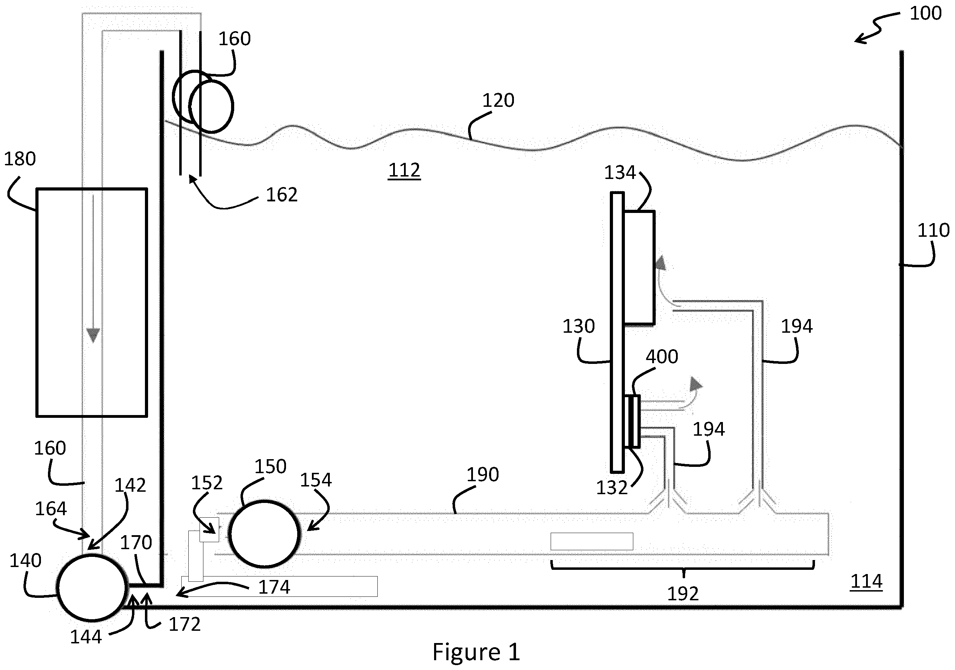

With these fundamentals in place, we will now consider some non-limiting examples to illustrate various implementations of aspects of the present technology. Figure 1 is a schematic diagram of an immersion cooling system 100. In the shown embodiment, the cooling system 100, comprises a container 110 configured to receive a dielectric cooling liquid 120 and to receive one or more electronic components 130 immersed in the dielectric cooling liquid 120. A pump 140 is used to cause a circulation of a first fraction of the dielectric cooling liquid 120 in the container 110 for convection cooling of the one or more electronic components 130. Another pump 150 is used to cause directing a second fraction of the dielectric cooling liquid 120 toward at least one of the one or more electronic components 130 for direct cooling of the electronic components 130. In the embodiment of Figure 1, the pump 150 is immersed in the dielectric cooling liquid 120 and comprises an inlet 152 configured for withdrawing the second fraction of the dielectric cooling liquid 120 from the container 110. The system 100 also comprises two piping arrangements 160 and 170. The piping arrangement 160 has an inlet 162 for withdrawing the first fraction of the dielectric cooling liquid 120 from an upper part 112 of the container 110, and an outlet 164 fluidly connected to an inlet 142 of the pump 140. The piping arrangement 170 has an inlet 172 fluidly connected to an outlet 144 of the pump 140, and an outlet 174 for returning the first fraction of the dielectric cooling liquid 120 to a lower part 114 of the container 110.

As shown on Figure 1, the cooling system 100 may comprise a heat exchanger 180 for extracting heat from the dielectric cooling liquid 120 present in the piping arrangement 160. Mounting the heat exchanger 180 on the piping arrangement 170, between the inlet 172 and the output 174, is also contemplated. Details of various embodiments of the heat exchanger 180 are provided hereinbelow.

In some embodiments, the cooling system 100 comprises one or more thermal transfer devices 400, which may also be called "cold plates" or "water blocks" (although not supplied with water in the present cooling system 100). As illustrated, a thermal transfer device 400 is mounted on a corresponding electronic component 130, more precisely on a processor 132 which is part of the electronic component 130. In various embodiments, one or more thermal transfer devices 400 may be mounted on corresponding central processing units (CPU), graphical processing units (GPU) and other heat generating devices of the electronic component 130.

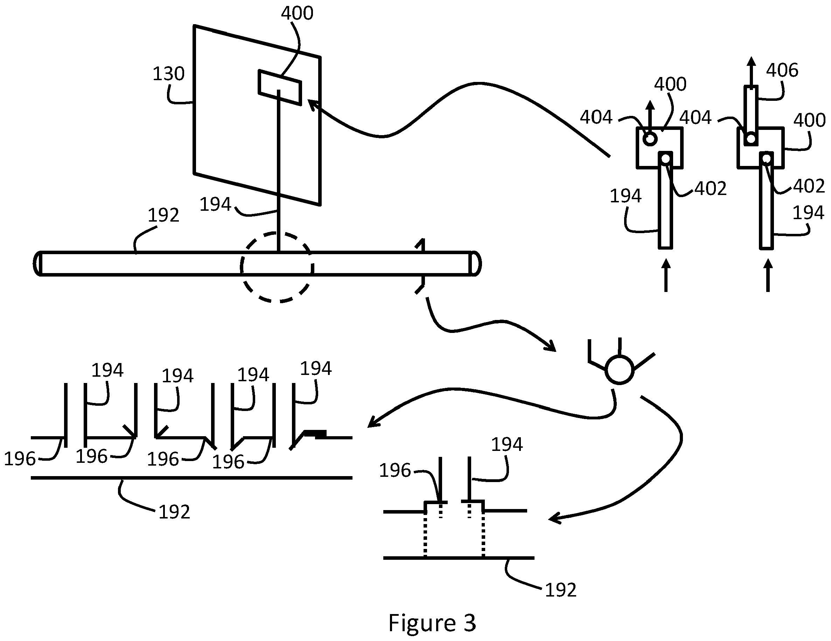

Also shown on Figure 1, the cooling system 100 also includes another piping arrangement 190 having a manifold 192 fluidly connected to an outlet 154 of the pump 150 for receiving the second fraction of the dielectric cooling from the pump 150. The piping arrangement 190 also includes one or more outlet pipes 194 fluidly connected to the manifold 192, each outlet pipe 194 being configured to bring a portion of the second fraction of the dielectric cooling liquid 120 in thermal contact with a corresponding electronic component 130. Each thermal transfer device 400 comprises an inlet 402 (Figure 3) fluidly connected to the pump 150 via the manifold 192 and a respective outlet pipe 194 for receiving a flow of the dielectric cooling liquid 120 directed toward the corresponding electronic components 130 by the pump 150. In some embodiments, some of the outlet pipes 194 deliver at least a part of the second fraction of the dielectric cooling liquid 120 to inlets 402 of thermal transfer devices 400 directly mounted on processors 132 or like heat generating devices of the electronic components 130. In the same or other embodiments, some of the outlet pipes 194 deliver at least a part of the second fraction of the dielectric cooling liquid 120 near other devices 134 of the electronic components 130. In either cases, the second fraction of the dielectric cooling liquid 120 is then released within the container 110. The second fraction of the dielectric cooling liquid 120 having absorbed heat from the electronic components 130, its density is less than that of the remainder of the dielectric cooling liquid 120 present in the container 110 and tends to move toward the upper part 112 of the container 110, where it is likely to be picked up by the inlet 162 of the piping arrangement 160 for cooling in the heat exchanger 180 and for recirculation.

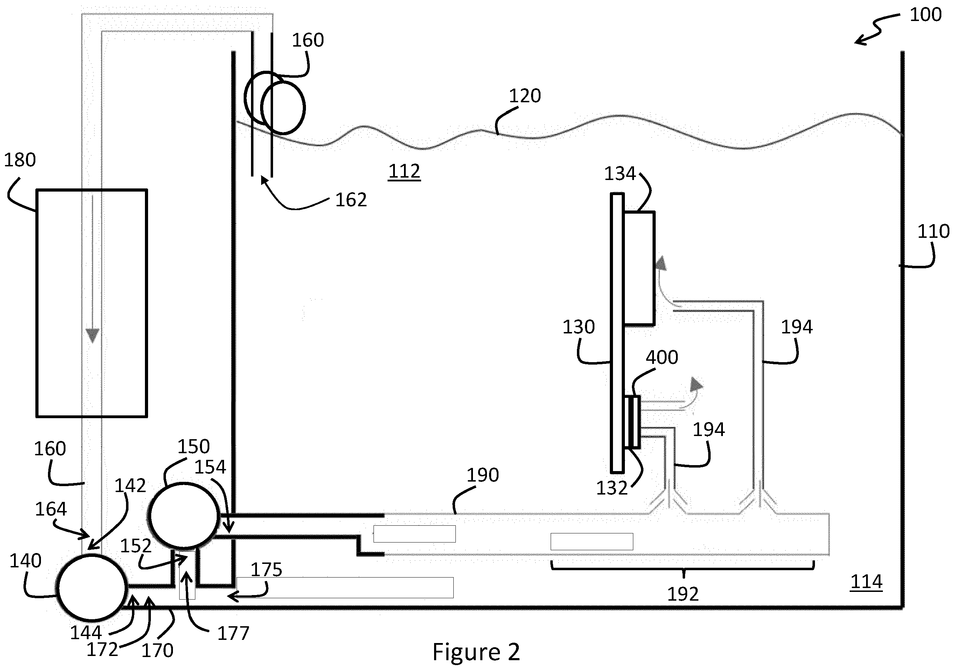

Figure 2 is a schematic diagram of another immersion cooling system 100. The cooling system 100 shown on Figure 2 contains many of the components introduced in the description of Figure 1 and a description of these components is not repeated herein. In the embodiment of Figure 2, the pump 150 is not immersed in the dielectric cooling liquid 120. The inlet 162 of the piping arrangement 160 withdraws both the first and second fractions of the dielectric cooling liquid 120 from the upper part 112 of the container 110. A first outlet 175 of the piping arrangement 170 returns the first fraction of the dielectric cooling liquid 120 to the lower part 114 of the container 110. A second outlet 177 of the piping arrangement 170 directs the second fraction of the dielectric cooling liquid 120 toward the inlet 152 of the pump 150, which forwards the second fraction of the dielectric cooling liquid 120 toward the piping arrangement 190 via its outlet 154, as in the case of Figure 1. It is also contemplated that the pump 150 might be connected to an independent piping arrangement (not shown) having its own inlet (not shown) for withdrawing the second fraction of the dielectric cooling liquid 120 from the upper part 112 of the container 110.

Considering Figures 1 and 2, in some non-limiting embodiments, the pump 140 and the pump 150 may be configured so that a pressure of the second fraction of the dielectric cooling liquid 120 directed toward the electronic components 130 is greater than a pressure of the first fraction of the dielectric cooling liquid 120 circulating in the container 110. This higher pressure provided by the pump 150 may help in overcoming the pressure drop of the dielectric cooling liquid 120 flowing in the thermal transfer devices 400. In the case of Figure 1, flow rates of the pumps 140 and 150 are independent. However in the case of Figure 2, the flow rate of the pump 140 is greater than the flow rate of the pump 150, so that the pump 140 may deliver both first and second fractions of the dielectric cooling liquid 120.

Given that the same dielectric cooling liquid 120 is circulated, as a first fraction thereof, within the container 110 and, as a second fraction thereof, in the manifold 192 and toward the electronic components 130, there is no need to prevent any leakage of the dielectric cooling liquid 120 between the manifold 190 and the container 110. For example, Figure 3 illustrates various types of connections of outlet pipes 194 between a manifold 192 and an electronic component 130. The outlet pipes 194 are not required to be sealingly connected to the manifold 192. Instead, the manifold includes a series of apertures 196, each of which is sized and positioned for receiving a lower end of a corresponding outlet pipe 194 for delivering some of the second fraction of the dielectric cooling liquid 120 toward the electronic component 130. While the apertures 196 may be dimensioned to provide a snug fit with the outlet pipes 194 received therein, some leakage of the second fraction of the dielectric cooling liquid 120 from the manifold 192 to the container 110 is acceptable, given that the container 110 is generally filled with such dielectric cooling liquid 120.

As a result, for inserting the electronic component 130 in the container 110, the thermal transfer device 400 and a corresponding outlet pipe 194 may be pre-installed on the electronic component 130, which can then be inserted in position within the container 110 so that the lower end of the outlet pipe 194 reaches a corresponding aperture 196 of the manifold 192. As such, a fluidic connection is obtained between the manifold 192 and the outlet pipes 194, without the need to use any particular type of sealable or complex connectors between the manifold 192 and the outlet pipes 194. Eventual removal of the electronic component 130 from the container 110 may be obtained without the need to disconnect any particular connector at the interface between the manifold 192 and the outlet pipes 194.

As mentioned hereinabove, each thermal transfer device 400 includes an inlet 402 fluidly connected to the pump 150 via the manifold 192 and a respective outlet pipe 194. Each thermal transfer device 400 also comprises an outlet 404 for releasing the flow of the dielectric cooling liquid 120 in the container 110. The flow of the dielectric cooling liquid 120 may be directly released in the container 110 from the outlets 404. A tube 406 may be fluidly connected to the outlet 404 of some of the thermal transfer devices 400 to redirect the flow of the dielectric cooling liquid 120 toward another component present in the container 110, for example another electronic component 130 or another heat transfer device 400.

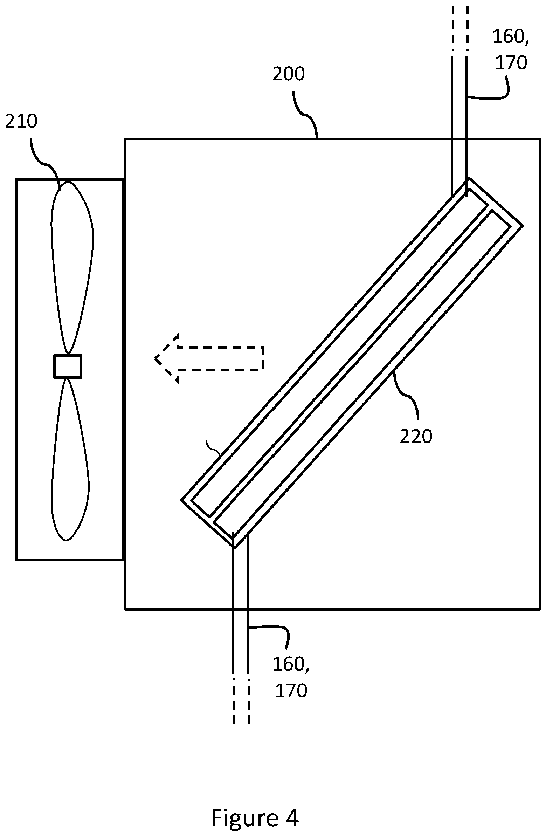

The heat exchanger 180 introduced in the description of Figures 1 and 2 may comprise an air-to-liquid heat exchanger. Figure 4 is a block diagram of an air-to-liquid heat exchanger 200 thermally connected to the piping arrangement 600 or 700. One or more fans 210 positioned downstream (as illustrated) or upstream of the air-to-liquid heat exchanger 200 cause an airflow through the air-to-liquid heat exchanger 200, to extract heat from the dielectric cooling liquid 120 flowing through a core 220 of the air-to-liquid heat exchanger 200.

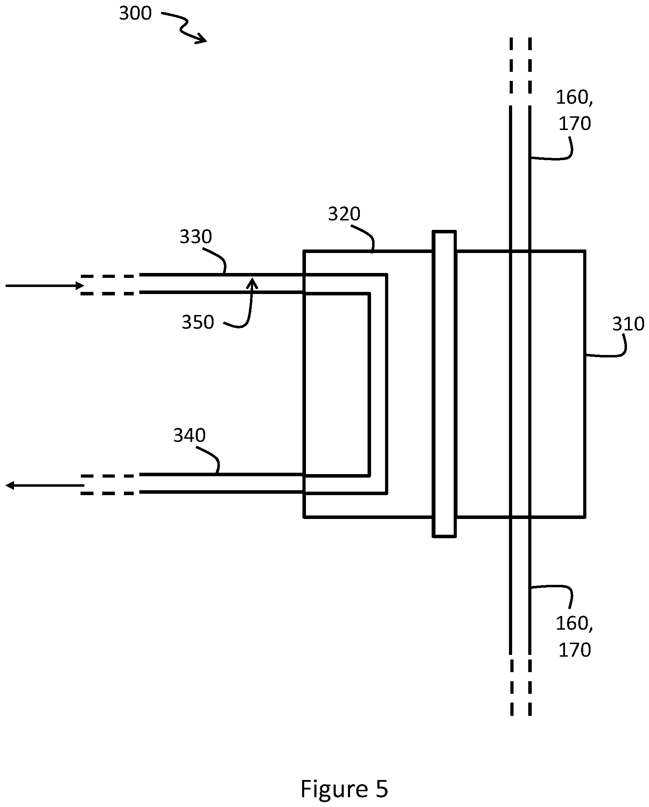

Alternatively, the heat exchanger 180 introduced in the description of Figures 1 and 2 may comprise a liquid-to-liquid heat exchanger. Figure 5 is a block diagram of a liquid-to-liquid heat exchanger 300 thermally connected to the piping arrangement 600 or 700. The liquid-to-liquid heat exchanger 300 includes a primary side 310 in thermal contact with the piping arrangements 160 or 170, and a secondary side 320 in thermal contact with the primary side 310. A flow of a liquid coolant 350, for example water, is received in the secondary side 320 via a liquid coolant inlet 330 and is returned from the secondary side 320 via a liquid coolant outlet 340. The flow of a liquid coolant 350 in the secondary side 320 allows to extract heat from the dielectric cooling liquid 120 present in the piping arrangement 160 or 170. The liquid coolant inlet 330 and the liquid coolant outlet 340 are connected to an external liquid coolant source (not shown), for example an external dry cooler.

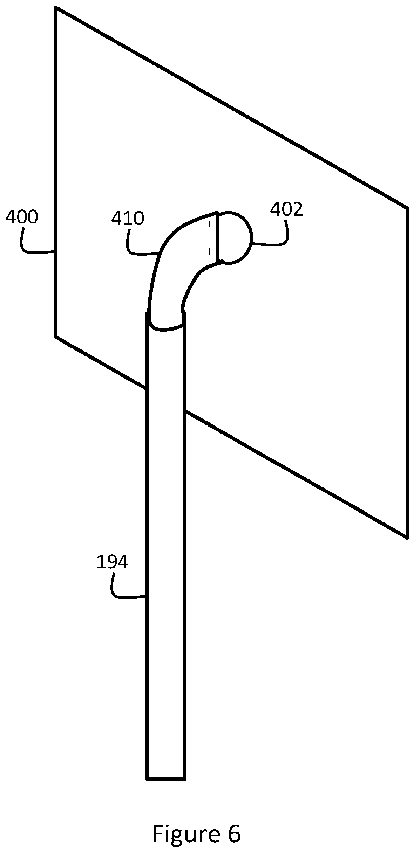

In an embodiment, the flow of dielectric cooling liquid 120 to some of the thermal transfer devices 400 may be prevented until a temperature of the dielectric cooling liquid 120 in the reservoir 110 reaches an unacceptable level. Figure 6 is a schematic representation of a phase change material (PCM) plug 410 for selectively allowing dielectric cooling fluid 120 to reach a thermal transfer device 400. One thermal transfer device 400 mounted on a corresponding electronic components 130 selectively receives a flow of the dielectric cooling liquid 120 directed toward the corresponding electronic components 130 by the pump 150. A plug 410 formed of a suitable PCM, for example wax, resin, paraffin, grease, silicone, synthetic glue and polymers, is inserted in the outlet pipe 194, for example near the inlet 402 of the thermal transfer device 400. Alternatively, the plug 410 may be formed at any point between the lower part of the outlet pipe 194 and the inlet 402 of the thermal transfer device 400, at the outlet 404 of the thermal transfer device 400, or at any point between the inlet 402 and outlet 404 of the thermal transfer device 400.

The PCM has a melting temperature higher than a normal operating temperature of the cooling system 100 and lower than a maximum safe operating temperature of the corresponding electronic component 130. In normal operation of the cooling system 100, the temperature of the dielectric cooling fluid 120 within the container 110 is lower than the melting temperature of the PCM. The plug 410 opposes the flow of the dielectric cooling liquid 120 within the thermal transfer device 400 under such condition. The plug 410 melts and allows the flow of the dielectric cooling liquid 120 in the thermal transfer device 400 when the temperature of the dielectric cooling liquid 120 exceeds the melting temperature of the PCM, in order to provide enhanced cooling of the electronic component 130.

It may be noted that, once melted, the plug 410 no longer exists and the PCM is dispersed within the dielectric cooling liquid 120. If the temperature of the dielectric cooling liquid 120 is reduced below the melting temperature of the PCM, the material of the plug 410 is expected to solidify and float in the upper part 112 of the container 110, or fall to the lower part 114 of the container, depending on its density.

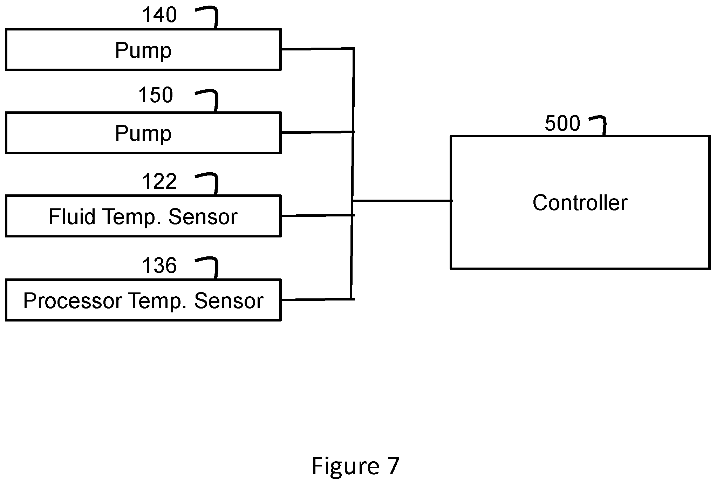

Figure 7 is a block diagram of a system for controlling the pumps 140 and 150. In a non-limiting embodiment, a fluid temperature sensor 122 may detect a temperature of the dielectric cooling liquid 120 in the container 110. A reading of this temperature may be provided by the fluid temperature sensor 122 to a controller 500. The controller 500 may control the operation of the pump 140 by starting the pump 140 when the temperature of the dielectric cooling liquid 120 rises above a first threshold, stopping the pump 140 when the temperature of the dielectric cooling liquid 120 falls below the first threshold. The controller 500 may implement a hysteresis so that the pump 140 is stopped when the temperature of the dielectric cooling liquid 120 falls to a temperature that is somewhat lower than the first threshold, in order to avoid frequently starting and stopping the pump 140. Use of a timer to maintain the pump 140 in operation for at least a minimum duration is also contemplated. In the same or another embodiment, a processor temperature sensor 136 may detect a temperature of the electronic component 130, for example a temperature of the processor 132. The controller 500 may control the operation of the pump 150 by starting the pump 150 when the temperature of the electronic component 130 rises above a second threshold, stopping the pump 150 when the temperature of the electronic component 130 falls below the second threshold. The controller 500 may implement a hysteresis so that the pump 150 is stopped when the temperature of the electronic component 130 falls to a temperature that is somewhat lower than the threshold, in order to avoid frequently starting and stopping the pump 150. Use of a timer to maintain the pump 150 in operation for at least a minimum duration is also contemplated. It is also contemplated that the controller 500 may start the pump 140 when the temperature of the electronic component 130 rises above the second threshold, whether the temperature of the dielectric cooling liquid 120 is above or below the first threshold, so that a circulation of the dielectric cooling liquid 120 is consistently maintained in the container 110 via the piping arrangement 160 when the temperature of the electronic component 130 reaches the second threshold and causes starting of the pump 150.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It should be expressly understood that not all technical effects mentioned herein need to be enjoyed in each and every embodiment of the present technology.

## Claims

1. A cooling system (100), comprising:
a container (110) having an open upper part (112) and being configured to receive a dielectric cooling liquid (120) and to receive one or more electronic components (130) immersed in the dielectric cooling liquid (120);
a first pump (140) configured to cause a circulation of a first fraction of the dielectric cooling liquid (120) in the container (110) for convection cooling of the one or more electronic components (130);
a second pump (150) configured to cause directing a second fraction of the dielectric cooling liquid (120) toward at least one of the one or more electronic components (130) for direct cooling of the at least one of the one or more electronic components (130);
a manifold (192) fluidly connected to an outlet (154) of the second pump (150) for receiving the second fraction of the dielectric cooling liquid (120) from the second pump (150); and
one or more outlet pipes (194) fluidly connected to the manifold (192), each outlet pipe (194) being configured to bring a portion of the second fraction of the dielectric cooling liquid (120) in thermal contact with a corresponding electronic component (130);
**characterized in that** the cooling system (100) further comprises:
a first piping arrangement (160) comprising:
an inlet (162) configured to withdraw the first fraction of the dielectric cooling liquid (120) from the open upper part (112) of the container (110), and
an outlet (164) fluidly connected to an inlet (142) of the first pump (140); and a second piping arrangement (170) comprising:
an inlet (172) fluidly connected to an outlet (144) of the first pump (140), and
an outlet (174, 175) configured to return the first fraction of the dielectric cooling liquid (120) to a lower part (114) of the container (110).

2. The cooling system (100) of claim 1, wherein the second pump (150) is configured to be immerged in the dielectric cooling liquid (120) and comprises an inlet (152) configured to withdraw the second fraction of the dielectric cooling liquid (120) from the container (110).

3. The cooling system (100) of claim 1, wherein:
the inlet (162) is further configured to withdraw the second fraction of the dielectric cooling liquid (120) from the open upper part (112) of the container (110),
the outlet is a first outlet (175), and
the second piping arrangement (170) further comprises a second outlet (177) configured to direct the second fraction of the dielectric cooling liquid (120) toward an inlet (152) of the second pump (150).

4. The cooling system (100) of any one of claims 1 to 3, further comprising a heat exchanger (180) in thermal contact with one of the first and second piping arrangements (160, 170), the heat exchanger (180) being configured to extract heat from the dielectric cooling liquid (120) present in the one of the first and second piping arrangements (160, 170), the heat exchanger (180) being selected from an air-to-liquid heat exchanger (200) and a liquid-to-liquid heat exchanger (300).

5. The cooling system (100) of any one of claims 1 to 4, wherein the outlet pipes (194) are not sealingly connected to the manifold (192).

6. The cooling system (100) of any one of claims 1 to 5, wherein each outlet pipe (194) is mounted to the corresponding electronic component (130) and configured to fluidly connect to the manifold (192) when the corresponding electronic component (130) is inserted in the container (110).

7. The cooling system (100) of any one of claims 1 to 6, wherein the first pump (140) and the second pump (150) are configured so that a pressure of the second fraction of the dielectric cooling liquid (120) directed toward the at least one of the one or more electronic components (130) is greater than a pressure of the first fraction of the dielectric cooling liquid (120) circulating in the container (110).

8. The cooling system (100) of any one of claims 1 to 7, further comprising one or more thermal transfer devices (400), each thermal transfer device (400) being adapted for mounting on a corresponding electronic component (130), each thermal transfer device (400) comprising an inlet (402) fluidly connected to the second pump (150) via a corresponding outlet pipe (194) and configured to receive a flow of the dielectric cooling liquid (120) directed toward the corresponding electronic components (130) by the second pump (150).

9. The cooling system (100) of any one of claims 1 to 7, further comprising:
one or more thermal transfer devices (400), each thermal transfer device (400) being adapted for mounting on a corresponding electronic component (130) and for selectively receiving a flow of the dielectric cooling liquid (120) directed toward the corresponding electronic components (130) by the second pump (150), each thermal transfer device comprising:
an inlet (402) fluidly connected to the second pump (150) via a corresponding outlet pipe (194), and
a plug (410) formed of a phase change material having a melting temperature higher than a normal operating temperature of the cooling system (100) and lower than a maximum safe operating temperature of the corresponding electronic component (130);
wherein:
the plug (410) is configured to oppose the flow of the dielectric cooling liquid (120) within the thermal transfer device (400) when a temperature of the dielectric cooling liquid (120) is lower than the melting temperature of the phase change material, and
the plug (410) is configured to melt and allow the flow of the dielectric cooling liquid (120) in the thermal transfer device (400) when a temperature of the dielectric cooling liquid (120) exceeds the melting temperature.

10. The cooling system (100) of claim 8 or 9, wherein at least one of the thermal transfer devices comprises an outlet (404) configured to release the flow of the dielectric cooling liquid (120) in the container (110).

11. The cooling system (100) of any one of claims 8 to 10, wherein at least one of the thermal transfer devices (400) comprises an outlet (404) fluidly connected to a tube (406) configured to redirect the flow of the dielectric cooling liquid (120) toward another component.

12. The cooling system (100) of any one of claims 1 to 11, wherein the manifold (192) comprises one or more apertures (196), each aperture (196) being configured to fluidly connect with a corresponding one of the one or more outlet pipes (194).

13. The cooling system (100) of any one of claims 1 to 12, further comprising:
a first sensor (122) of a temperature of the dielectric cooling liquid (120); and
a controller (500) configured to:
receive, from the first sensor (122), a signal indicating a temperature of the dielectric cooling liquid (120), and
cause an operation of the first pump (150) in response to the temperature of the dielectric cooling liquid (120) being greater than a first threshold.

14. The cooling system (100) of claim 13, further comprising:
a second sensor (136) of a temperature of the one or more electronic components (130);
wherein the controller (500) is further configured to cause an operation of the second pump (150) in response to the temperature of the one or more electronic components (130) being greater than a second threshold.

## Patentansprüche

1. Kühlsystem (100), umfassend:
einen Behälter (110), der einen offenen oberen Teil (112) aufweist und so ausgelegt ist, dass er eine dielektrische Kühlflüssigkeit (120) aufnimmt und ein oder mehrere in die dielektrische Kühlflüssigkeit (120) eingetauchte elektronische Komponenten (130) aufnimmt;
eine erste Pumpe (140), die so ausgelegt ist, eine Zirkulation eines ersten Anteils der dielektrischen Kühlflüssigkeit (120) im Behälter (110) zur Konvektionskühlung der einen oder mehreren elektronischen Komponenten (130) zu bewirken;
eine zweite Pumpe (150), die so ausgelegt ist, einen zweiten Anteil der dielektrischen Kühlflüssigkeit (120) in Richtung von mindestens einer der einen oder mehreren elektronischen Komponenten (130) zu leiten, um die mindestens eine der einen oder mehreren elektronischen Komponenten (130) direkt zu kühlen;
einen Verteiler (192), der fließend mit einem Auslass (154) der zweiten Pumpe (150) verbunden ist, um den zweiten Anteil der dielektrischen Kühlflüssigkeit (120) von der zweiten Pumpe (150) aufzunehmen; und
ein oder mehrere Auslassrohre (194), die fließend mit dem Verteiler (192) verbunden sind, wobei jedes Auslassrohr (194) so ausgelegt ist, einen Teil des zweiten Anteils der dielektrischen Kühlflüssigkeit (120) in thermischen Kontakt mit einer entsprechenden elektronischen Komponente (130) zu bringen;
**dadurch gekennzeichnet, dass** das Verfahren (100) ferner Folgendes umfasst:
eine erste Rohrleitungsanordnung (160), umfassend:
einen Einlass (162), der so ausgelegt ist, den ersten Teil der dielektrischen Kühlflüssigkeit (120) aus dem offenen oberen Teil (112) des Behälters (110) abzuziehen, und
einen Auslass (164), der fließend mit einem Einlass (142) der ersten Pumpe (140) verbunden ist; und
eine zweite Rohrleitungsanordnung (170), umfassend:
einen Einlass (172), der fließend mit einem Auslass (144) der ersten Pumpe (140) verbunden ist; und
einen Auslass (174, 175), der so ausgelegt ist, den ersten Teil der dielektrischen Kühlflüssigkeit (120) zu einem unteren Teil (114) des Behälters (110) zurückzuführen.

2. Kühlsystem (100) nach Anspruch 1, wobei die zweite Pumpe (150) zum Eintauchen in die dielektrische Kühlflüssigkeit (120) ausgelegt ist und einen Einlass (152) umfasst, der zum Abziehen des zweiten Anteils der dielektrischen Kühlflüssigkeit (120) aus dem Behälter (110) ausgelegt ist.

3. Kühlsystem (100) nach Anspruch 1, wobei:
der Einlass (162), der ferner so ausgelegt ist, den zweiten Teil der dielektrischen Kühlflüssigkeit (120) aus dem offenen oberen Teil (112) des Behälters (110) abzuziehen,
der Auslass ein erster Auslass (175) ist, und
die zweite Rohrleitungsanordnung (170) ferner einen zweiten Auslass (177) umfasst, der so ausgelegt ist, den zweiten Anteil der dielektrischen Kühlflüssigkeit (120) in Richtung eines Einlasses (152) der zweiten Pumpe (150) zu leiten.

4. Kühlsystem (100) nach einem der Ansprüche 1 bis 3, das ferner einen Wärmetauscher (180) in thermischem Kontakt mit einer der ersten und zweiten Rohrleitungsanordnungen (160, 170) umfasst, wobei der Wärmetauscher (180) so ausgelegt ist, Wärme aus der in der einen der ersten und zweiten Rohrleitungsanordnungen (160, 170) vorhandenen dielektrischen Kühlflüssigkeit (120) zu extrahieren, wobei der Wärmetauscher (180) aus einem Luft-Flüssigkeits-Wärmetauscher (200) und einem Flüssigkeit-Flüssigkeits-Wärmetauscher (300) ausgewählt ist.

5. Kühlsystem (100) nach einem der Ansprüche 1 bis 4, wobei die Auslassrohre (194) nicht dichtend mit dem Verteiler (192) verbunden sind.

6. Kühlsystem (100) nach einem der Ansprüche 1 bis 5, wobei jedes Auslassrohr (194) an der entsprechenden elektronischen Komponente (130) montiert ist und so ausgelegt ist, dass es eine Fluidverbindung mit dem Verteiler (192) herstellt, wenn die entsprechende elektronische Komponente (130) in den Behälter (110) eingesetzt ist.

7. Kühlsystem (100) nach einem der Ansprüche 1 bis 6, wobei die erste Pumpe (140) und die zweite Pumpe (150) so ausgelegt sind, dass ein Druck des zweiten Anteils der dielektrischen Kühlflüssigkeit (120), der auf die mindestens eine der einen oder mehreren elektronischen Komponenten (130) gerichtet ist, größer ist als ein Druck des ersten Anteils der dielektrischen Kühlflüssigkeit (120), der im Behälter (110) zirkuliert.

8. Kühlsystem (100) nach einem der Ansprüche 1 bis 7, das ferner ein oder mehrere Wärmeübertragungsgeräte (400) umfasst, wobei jedes Wärmeübertragungsgerät (400) zur Montage an einer entsprechenden elektronischen Komponente (130) geeignet ist und jedes Wärmeübertragungsgerät (400) einen Einlass (402) umfasst, der über ein entsprechendes Auslassrohr (194) fließend mit der zweiten Pumpe (150) verbunden ist und so ausgelegt ist, einen Strom der dielektrischen Kühlflüssigkeit (120) aufzunehmen, der von der zweiten Pumpe (150) in Richtung der entsprechenden elektronischen Komponenten (130) geleitet wird.

9. Kühlssystem (100) nach einem der Ansprüche 1 bis 7, ferner umfassend:
eine oder mehrere Wärmeübertragungsvorrichtungen (400), wobei jede Wärmeübertragungsvorrichtung (400) zur Montage auf einer entsprechenden elektronischen Komponente (130) und zum selektiven Empfangen eines Stroms der dielektrischen Kühlflüssigkeit (120) angepasst ist, der durch die zweite Pumpe (150) in Richtung der entsprechenden elektronischen Komponenten (130) geleitet wird, wobei jede Wärmeübertragungsvorrichtung umfasst:
einen Einlass (402), der über ein entsprechendes Auslassrohr (194) fließend mit der zweiten Pumpe (150) ist, und
einen Stopfen (410), der aus einem Phasenwechselmaterial gebildet ist, das eine Schmelztemperatur aufweist, die höher ist als eine normale Betriebstemperatur des Kühlsystems (100) und niedriger als eine maximal sichere Betriebstemperatur der entsprechenden elektronischen Komponente (130);
wobei:
der Stopfen (410) so ausgelegt ist, dass er dem Fluss der dielektrischen Kühlflüssigkeit (120) innerhalb der Wärmeübertragungsvorrichtung (400) entgegenwirkt, wenn eine Temperatur der dielektrischen Kühlflüssigkeit (120) niedriger ist als die Schmelztemperatur des Phasenwechselmaterials, und
der Stopfen (410) so ausgelegt ist, dass er schmilzt und den Fluss der dielektrischen Kühlflüssigkeit (120) in der Wärmeübertragungsvorrichtung (400) ermöglicht, wenn eine Temperatur der dielektrischen Kühlflüssigkeit (120) die Schmelztemperatur überschreitet.

10. Kühlsystem (100) gemäß Anspruch 8 oder 9, wobei mindestens eine der Wärmeübertragungsvorrichtungen einen Auslass (404) umfasst, der so ausgelegt ist, den Fluss der dielektrischen Kühlflüssigkeit (120) in dem Behälter (110) freizugeben.

11. Kühlsystem (100) gemäß einem der Ansprüche 8 bis 10, wobei mindestens eines der Wärmeübertragungsgeräte (400) einen Auslass (404) umfasst, der fließend mit einem Rohr (406) verbunden ist, das so ausgelegt ist, den Fluss der dielektrischen Kühlflüssigkeit (120) in Richtung einer anderen Komponente umzuleiten.

12. Kühlsystem (100) gemäß einem der Ansprüche 1 bis 11, wobei der Verteiler (192) eine oder mehrere Öffnungen (196) umfasst, wobei jede Öffnung (196) so ausgelegt ist, dass sie eine Fluidverbindung mit einem entsprechenden der einen oder mehreren Auslassrohre (194) herstellt.

13. Kühlsystem (100) nach Anspruch 1 bis 12, ferner umfassend:
einen ersten Sensor (122) für die Temperatur der dielektrischen Kühlflüssigkeit (120); und
eine Steuerung (500), die so ausgelegt ist,
dass ein Signal vom ersten Sensor (122) zur Anzeige einer Temperatur der dielektrischen Kühlflüssigkeit (120) empfangen wird, und
der Betrieb der ersten Pumpe (150) als Reaktion darauf veranlasst wird, dass die Temperatur der dielektrischen Kühlflüssigkeit (120) über einem ersten Schwellenwert liegt.

14. Kühlsystem (100) nach Anspruch 13, ferner umfassend:
einen zweiten Sensor (136) für eine Temperatur der einen oder mehreren elektronischen Komponenten (130);
wobei die Steuerung (500) ferner so ausgelegt ist, einen Betrieb der zweiten Pumpe (150) als Reaktion darauf zu veranlassen, dass die Temperatur der einen oder mehreren elektronischen Komponenten (130) über einem zweiten Schwellenwert liegt.

## Revendications

1. Système de refroidissement (100), comprenant :
un récipient (110) ayant une partie supérieure ouverte (112) et étant configuré pour recevoir un liquide de refroidissement diélectrique (120) et pour recevoir un ou plusieurs composants électroniques (130) immergés dans le liquide de refroidissement diélectrique (120) ;
une première pompe (140) configurée pour amener une circulation d'une première fraction du liquide de refroidissement diélectrique (120) dans le récipient (110) pour le refroidissement par convection des un ou plusieurs composants électroniques (130) ;
une seconde pompe (150) configurée pour diriger une seconde fraction du liquide de refroidissement diélectrique (120) vers au moins l'un des un ou plusieurs composants électroniques (130) pour un refroidissement direct de l'au moins un des un ou plusieurs composants électroniques (130) ;
un collecteur (192) relié fluidiquement à une sortie (154) de la seconde pompe (150) pour recevoir la seconde fraction du liquide de refroidissement diélectrique (120) provenant de la seconde pompe (150) ; et
un ou plusieurs tuyaux de sortie (194) reliés fluidiquement au collecteur (192), chaque tuyau de sortie (194) étant configuré pour amener une partie de la seconde fraction du liquide de refroidissement diélectrique (120) en contact thermique avec un composant électronique (130) correspondant ;
**caractérisé en ce que** le système de refroidissement (100) comprend en outre :
un premier agencement de tuyauterie (160) comprenant :
une entrée (162) configurée pour extraire la première fraction du liquide de refroidissement diélectrique (120) de la partie supérieure ouverte (112) du récipient (110), et
une sortie (164) reliée fluidiquement à une entrée (142) de la première pompe (140) ; et
un second agencement de tuyauterie (170) comprenant :
une entrée (172) reliée fluidiquement à une sortie (144) de la première pompe (140) ; et
une sortie (174, 175) configurée pour renvoyer la première fraction du liquide de refroidissement diélectrique (120) vers une partie inférieure (114) du récipient (110).

2. Système de refroidissement (100) selon la revendication 1, dans lequel la seconde pompe (150) est configurée pour être immergée dans le liquide de refroidissement diélectrique (120) et comprend une entrée (152) configurée pour extraire la seconde fraction du liquide de refroidissement diélectrique (120) du récipient (110).

3. Système de refroidissement (100) selon la revendication 1, dans lequel :
l'entrée (162) est en outre configurée pour extraire la seconde fraction du liquide de refroidissement diélectrique (120) de la partie supérieure ouverte (112) du récipient (110),
la sortie est une première sortie (175), et
le second agencement de tuyauterie (170) comprend en outre une seconde sortie (177) configurée pour diriger la seconde fraction du liquide de refroidissement diélectrique (120) vers une entrée (152) de la seconde pompe (150).

4. Système de refroidissement (100) selon l'une quelconque des revendications 1 à 3, comprenant en outre un échangeur de chaleur (180) en contact thermique avec l'un des premier et second agencements de tuyauterie (160, 170), l'échangeur de chaleur (180) étant configuré pour extraire la chaleur du liquide de refroidissement diélectrique (120) présent dans l'un des premier et second agencements de tuyauterie (160, 170), l'échangeur de chaleur (180) étant choisi parmi un échangeur de chaleur air-liquide (200) et un échangeur de chaleur liquide-liquide (300).

5. Système de refroidissement (100) selon l'une quelconque des revendications 1 à 4, dans lequel les tuyaux de sortie (194) ne sont pas reliés de manière étanche au collecteur (192).

6. Système de refroidissement (100) selon l'une quelconque des revendications 1 à 5, dans lequel chaque tuyau de sortie (194) est monté sur le composant électronique (130) correspondant et configuré pour être relié fluidiquement au collecteur (192) lorsque le composant électronique (130) correspondant est inséré dans le récipient (110).

7. Système de refroidissement (100) selon l'une quelconque des revendications 1 à 6, dans lequel la première pompe (140) et la seconde pompe (150) sont configurées de sorte qu'une pression de la seconde fraction du liquide de refroidissement diélectrique (120) dirigée vers l'au moins un des un ou plusieurs composants électroniques (130) est supérieure à une pression de la première fraction du liquide de refroidissement diélectrique (120) circulant dans le récipient (110).

8. Système de refroidissement (100) selon l'une quelconque des revendications 1 à 7, comprenant en outre un ou plusieurs dispositifs de transfert thermique (400), chaque dispositif de transfert thermique (400) étant conçu pour être monté sur un composant électronique (130) correspondant, chaque dispositif de transfert thermique (400) comprenant une entrée (402) reliée fluidiquement à la seconde pompe (150) par l'intermédiaire d'un tuyau de sortie (194) correspondant et configurée pour recevoir un écoulement du liquide de refroidissement diélectrique (120) dirigé vers les composants électroniques (130) correspondants par la seconde pompe (150).

9. Système de refroidissement (100) selon l'une quelconque des revendications 1 à 7, comprenant en outre :
un ou plusieurs dispositifs de transfert thermique (400), chaque dispositif de transfert thermique (400) étant conçu pour être monté sur un composant électronique (130) correspondant et pour recevoir sélectivement un écoulement du liquide de refroidissement diélectrique (120) dirigé vers les composants électroniques (130) correspondants par la seconde pompe (150), chaque dispositif de transfert thermique comprenant :
une entrée (402) reliée fluidiquement à la seconde pompe (150) par l'intermédiaire d'un tuyau de sortie (194) correspondant, et
un bouchon (410) formé d'un matériau à changement de phase ayant une température de fusion supérieure à une température de fonctionnement normale du système de refroidissement (100) et inférieure à une température de fonctionnement maximale sûre du composant électronique (130) correspondant ;
dans lequel :
le bouchon (410) est configuré pour s'opposer à l'écoulement du liquide de refroidissement diélectrique (120) à l'intérieur du dispositif de transfert thermique (400) lorsqu'une température du liquide de refroidissement diélectrique (120) est inférieure à la température de fusion du matériau à changement de phase, et
le bouchon (410) est configuré pour fondre et permettre l'écoulement du liquide de refroidissement diélectrique (120) dans le dispositif de transfert thermique (400) lorsqu'une température du liquide de refroidissement diélectrique (120) dépasse la température de fusion.

10. Système de refroidissement (100) selon la revendication 8 ou 9, dans lequel au moins l'un des dispositifs de transfert thermique comprend une sortie (404) configurée pour libérer l'écoulement du liquide de refroidissement diélectrique (120) dans le récipient (110).

11. Système de refroidissement (100) selon l'une quelconque des revendications 8 à 10, dans lequel au moins l'un des dispositifs de transfert thermique (400) comprend une sortie (404) reliée fluidiquement à un tube (406) configuré pour rediriger l'écoulement du liquide de refroidissement diélectrique (120) vers un autre composant.

12. Système de refroidissement (100) selon l'une quelconque des revendications 1 à 11, dans lequel le collecteur (192) comprend une ou plusieurs ouvertures (196), chaque ouverture (196) étant configurée pour être reliée fluidiquement à l'un correspondant parmi les un ou plusieurs tuyaux de sortie (194).

13. Système de refroidissement (100) selon l'une quelconque des revendications 1 à 12, comprenant en outre :
un premier capteur (122) d'une température du liquide de refroidissement diélectrique (120) ; et
un dispositif de commande (500) configuré pour :
recevoir, en provenance du premier capteur (122), un signal indiquant une température du liquide de refroidissement diélectrique (120), et
amener un fonctionnement de la première pompe (150) en réponse au fait que la température du liquide de refroidissement diélectrique (120) est supérieure à un premier seuil.

14. Système de refroidissement (100) selon la revendication 13, comprenant en outre :
un second capteur (136) d'une température des un ou plusieurs composants électroniques (130) ;
dans lequel le dispositif de commande (500) est en outre configuré pour amener un fonctionnement de la seconde pompe (150) en réponse au fait que la température des un ou plusieurs composants électroniques (130) est supérieure à un second seuil.
